# EUROPEAN PATENT SPECIFICATION

(11) **EP 3 185 326 B1**
(45) Date of publication and mention of the grant of the patent: **29.04.2020**
(21) Application number: 16184623.3
(22) Date of filing: 17.08.2016
(51) Int. Cl.: H01L 51/52, H01L 27/32

(54) **DISPLAY PANEL WITH LUMINANCE EFFICIENCY IMPROVEMENT, DISPLAY DEVICE, AND METHOD OF FABRICATING THE DISPLAY PANEL**
ANZEIGETAFEL MIT LUMINANZEFFIZIENZVERBESSERUNG, ANZEIGEVORRICHTUNG UND VERFAHREN ZUR HERSTELLUNG DER ANZEIGETAFEL
PANNEAU D'AFFICHAGE AVEC AMÉLIORATION DE L'EFFICACITÉ DE LUMINANCE, DISPOSITIF D'AFFICHAGE ET PROCÉDÉ DE FABRICATION DU PANNEAU D'AFFICHAGE

(30) Priority: 21.12.2015 KR 20150183216
(43) Date of publication of application: 28.06.2017
(73) Proprietor: LG Display Co., Ltd., Yeongdeungpo-gu Seoul, 07336 (KR)
(72) Inventor: KIM, Eui-Tae, 10907 Gyeonggi-do (KR); SHIN, Ki-Seob, 05645 Seoul (KR)
(74) Representative: Jackson, Richard Eric

(56) References cited:
- US-A1- 2013 214 301
- US-A1- 2015 008 403
- US-A1- 2015 188 091
- US-A1- 2015 318 447

## Description

### BACKGROUND OF THE INVENTION

### Field of the Invention

The present invention relates to a display panel with luminance efficiency improvement, a display device, and a method of fabricating the display panel.

### Description of the Related Art

A display device is a device for visually displaying data, such as a liquid crystal display, an electrophoretic display, an organic light emitting display, an inorganic electroluminescent (EL) display, an electroluminescent display, a field emission display, a surface conduction electron emitter display, a plasma display, a cathode ray display and the like. For example, US 2015/188091 A1 discloses an EL display apparatus which includes a first and a second substrate. The second substrate has an insulating layer which defines a light transmission area, from which light is transmitted through a first member. There is also a second member adjacent the first member which has a lower refractive index than the first member.

Among these displays, the organic light emitting display is a display including two different electrodes and an emission layer interposed therebetween. In this display, when electrons generated in one electrode and holes generated in the other electrodes are injected into the emission layer, the injected electrons and holes are combined to generate excitons. While the generated excitons are falling from an excited state to a ground state, light is emitted from the emission layer, thereby displaying an image.

Some display devices can provide a mirror function or a transmission function. The mirror function refers to a function to reflect external light by a reflective material formed, or located, in a display panel. The transmission function refers to a function to transmit external light through a display panel.

However, such a mirror function or transmission function may deteriorate luminance efficiency of light emitted from pixels of the display panel. Therefore, there is a need of a display panel and a display device which are capable of improving the luminance efficiency.

US 2015/188091 A1, US 2013/214301 A1, US 2015/008403 A1 and US 2015/318447 A1 disclose display devices having banks facing partitions.

### SUMMARY OF THE INVENTION

The present disclosure provides a display panel and a display device which are capable of improving luminance efficiency of a mirror display panel or a transmission display panel, and a method for fabricating the display panel.

In addition, the present disclosure provides a display panel and a display device which are capable of outputting light emitted from an emission area outside the display panel without being reflected by a mirror, and a method for fabricating the display panel.

In addition, the present disclosure provides a display panel and a display device which are capable of outputting light emitted from an emission area outside the display panel without being totally reflected at an upper substrate, and a method for fabricating the display panel.

In addition, the present disclosure provides a display panel and a display device which are capable of specifically adjusting a viewing angle of light emitted from an emission area, and a method for fabricating the display panel.

The present invention provides a display panel according to claim 1.

According to another embodiment of the present invention, there is provided a method for fabricating a display in accordance with claim 8.

The method may further include coating a negative photoresist on the second substrate and then forming reverse tapered partitions by exposing the coated negative photoresist.

### [Advantages of the Invention]

The present invention can implement a display panel and a display device which are capable of improving the luminance efficiency of a mirror display panel or a transmission display panel.

In addition, the present invention can implement a display panel and a display device which are capable of outputting light emitted from an emission area outside the display panel without being reflected by a mirror.

In addition, according to the present invention, since partitions can be formed by using a photomask used to form partitions, it is possible to fabricate a display panel and a display device without a separate photomask.

### BRIEF DESCRIPTION OF THE DRAWINGS

**FIG. 1** is a view showing the configuration of a display device to which one embodiment of the present invention is applied.
**FIG. 2** is a sectional view showing the configuration of an organic light emitting display panel with a mirror function.
**FIG. 3** is a sectional view showing the configuration of an organic light emitting display panel with a transmission function.
**FIG. 4** is a sectional view of a substrate on which partitions are formed, or located, according to one embodiment not forming part of the present invention.
**FIG. 5** is a sectional view of a substrate on which partitions are formed, or located, according to an embodiment of the present invention.
**FIG. 6** is a sectional view of a substrate on which partitions are formed, or located, according to still another embodiment not forming part of the present invention.
**FIG. 7** is a view showing the configuration of a display panel according to one embodiment not forming part of the present invention.
**FIG. 8** is a view showing the configuration of a mirror display panel according to another embodiment not forming part of the present invention.
**FIG. 9** is a view showing a relationship between a reverse taper angle of partitions according to one embodiment not forming part of the present invention and a viewing angle.
**FIG. 10** is a view showing a degree of improvement of luminance efficiency when a reverse tapered low refractive index organic film according to one embodiment is used to form partitions.
**FIG. 11** is a view showing a degree of improvement of luminance efficiency when a two-step reverse tapered low refractive index organic film according to another embodiment of the present invention is used to form partitions.
**FIG. 12** is a view showing the configuration of partitions according to another embodiment not forming part of the present invention.
**FIG. 13** is a view showing a process of fabricating a display panel according to one embodiment.
**FIG. 14** is a view for explaining a partition forming process according to one embodiment.

### DETAILED DESCRIPTION

The above objects, features and advantages will become more clearly apparent from the following detailed description in conjunction with the accompanying drawings. Therefore, the technical ideas of the present invention can be easily understood and practiced by those skilled in the art.

In the following detailed description of the present invention, concrete description on related functions or constructions will be omitted if it is deemed that the functions and/or constructions may hinder the understanding of the present invention. Hereinafter, preferred embodiments of the present invention will be described in detail with reference to the accompanying drawings. Throughout the drawings, the same or similar elements are denoted by the same reference numerals. In the present specification, a detailed description of well-known functions and configurations will be omitted so as not to make the scope of the present invention unclear.

In the following description, the term "upper portion (or lower portion)" or "upper (or lower)" refers to not only including or forming a certain configuration in contact with an upper surface (or lower surface) of a base but also including or forming other configurations between the certain configuration and the base or below the base. In addition, in the following description, the terms "first," "second," "A," "B," "(a)," "(b)," and so on are just used to distinguish one element from another but are not intended to limit the essence, sequence, order or number of elements. When a certain element is "connected," "coupled" or "contacted" to another, it is to be understood that the certain element may be "connected," "coupled" or "contacted" to another directly or via a different element. A reverse taper may be any taper that results in an overhanging structure.

A display device of the present invention outputs external input image data by using a variety of light sources. In this course, the image data are divided into R (red), G (green), B (blue), and selectively W (white) or black to be provided to the display device. The display device may provide other functions, rather than providing the image data. In particular, when the display device further includes a function of sensing light, it is possible to adjust image luminance or color balance of images output depending on a magnitude of external light.

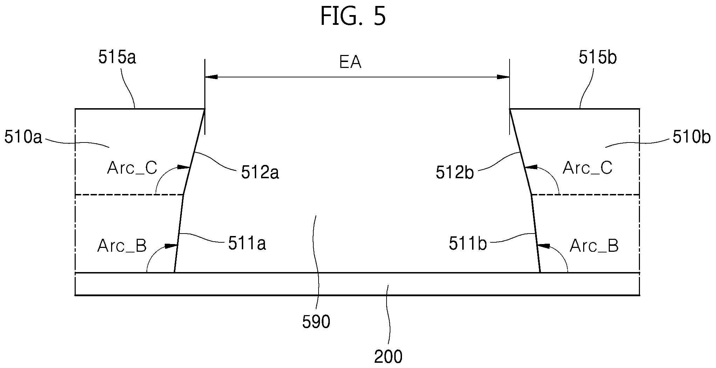

The embodiment of the present invention is shown in figure 5. The other figures, although they do not show embodiments of the present invention, are useful to understand the invention or parts thereof.

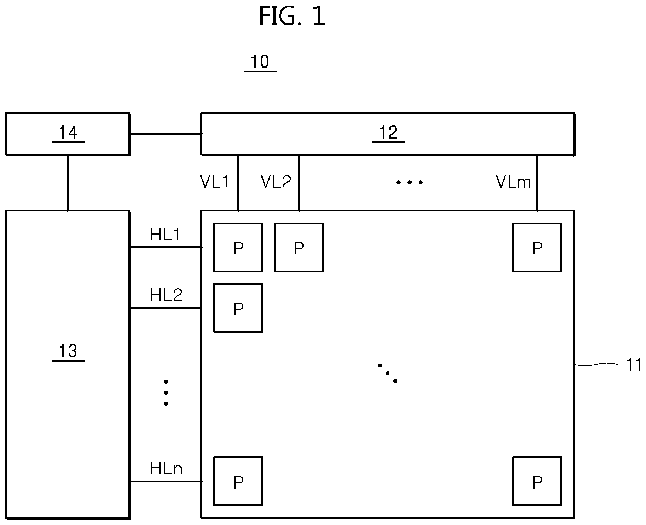

**FIG. 1** is a view showing the configuration of a display device to which one embodiment of the present invention is applied. A display device of **FIG. 1** may include, but is not limited to, an organic light emitting display panel as a display panel 11. The present invention may be applied to an organic light emitting display panel of either a top surface emission type or a bottom surface emission type.

Referring to **FIG. 1****,** a display device 100 includes a display panel 11 having a plurality of first lines VL1 to VLm formed, or located, in a first direction (for example, a vertical direction) and a plurality of second lines HL1 to HLn formed, or located, in a second direction (for example, a horizontal direction), a first driver 12 for applying a first signal to the plurality of first lines VL1 to Vlm, a second driver 13 for applying a second signal to the plurality of second lines HL1 to HLn, a timing controller 14 for controlling the first driver 12 and the second driver 13, etc.

The display panel 11 has a plurality of pixels defined at intersections of the plurality of first lines VL1 to VLm formed, or located, in the first direction (for example, the vertical direction) and the plurality of second lines HL1 to HLn formed, or located, in the second direction (for example, the horizontal direction).

Each of the first and second drivers 12 and 13 may include at least one driver IC which outputs a signal for displaying an image.

The plurality of first lines VL1 to VLm formed, or located, in the first direction in the display panel 11 may be, for example, data lines which are formed, or located, in the vertical direction (the first direction) and transfer a data voltage (the first signal) to a pixel column in the vertical direction. The first driver 12 may be a data driver for applying the data voltage to the data lines.

The plurality of second lines HL1 to HLn formed, or located, in the second direction in the display panel 11 may be gate lines which are formed, or located, in the horizontal direction (the second direction) and transfer a scan signal (the second signal) to the pixel column in the horizontal direction. The second driver 13 may be a scan driver for applying the scan signal to the gate lines.

The display panel 11 may include a pad part (not shown) used to interconnect the first driver 12 and the second driver 13. When the first signal is applied from the first driver 12 to the plurality of first lines VL1 to VLm, the pad part transfers the first signal to the display panel 11. Similarly, when the second signal is applied from the second driver 13 to the plurality of second lines HL1 to HLn, the pad part transfers the second signal to the display panel 11.

Each of the pixels includes one or more subpixels. A subpixel used herein refers to a unit to allow an organic light emitting element to emit light of a particular color through a certain kind of color filter formed, or located, therein or without any color filter. Colors defined in the subpixel may include, but is not limited to, red (R), green (G), blue (B) and optionally white (W). Each subpixel includes a separate thin film transistor and an electrode connected thereto. Therefore, in the following description, subpixels constituting a pixel will be collectively referred to as one pixel region. That is, a group of subpixels may constitute a pixel. For convenience, subpixels will be referred to as a pixel.

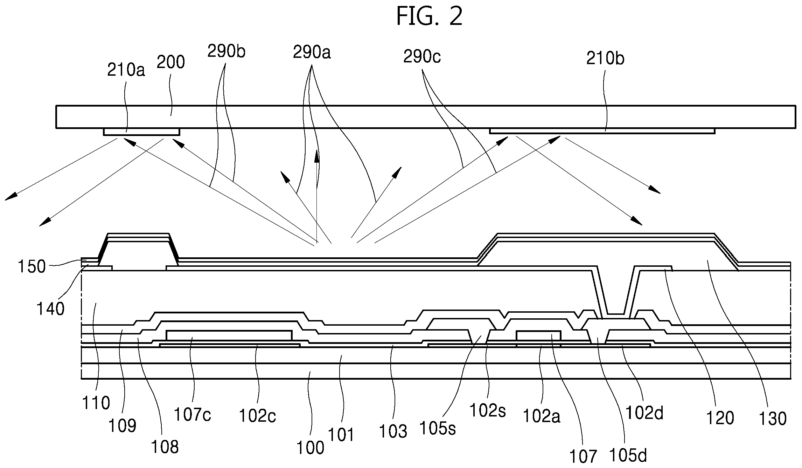

**FIG. 2** is a sectional view showing the configuration of an organic light emitting display panel with a mirror function. **FIG. 2** is also a sectional view of a pixel of the mirror display panel.

As shown in **FIG. 2****,** on a first substrate 100 are arranged a buffer 101, an active layer 102a, conductive portions 102s and 102d formed, or located, in both sides of the active layer 102a, a gate 107, a gate insulating film 103 formed, or located, between the gate 107 and the active layer 102a, a source 105s, a drain 105d, a first electrode 120 for controlling emission for each pixel, a second electrode 150 disposed over a plurality of pixels, and a bank 130 defining an emission region. In addition, an organic light emitting layer 140 is interposed between the first electrode 120 and the second electrode 150 and may also be disposed on the bank 130. In addition, two layers 107c and 102c for a storage capacitor are disposed.

The pixel structure of **FIG. 2** is just illustrative but the pixel may have different structures, for example, a TFT structure, without being limited thereto.

As shown in **FIG. 2****,** mirrors 210a and 210b for reflecting external light are arranged on a second substrate 200. Due to a distance between the mirrors 210a and 210b and the organic light emitting layer 140 of the first substrate 100, some 290a of light emitted from the organic light emitting layer 140 travels upward, whereas some 290b and 290c is totally reflected toward an edge, which may result in reduction of luminance efficiency.

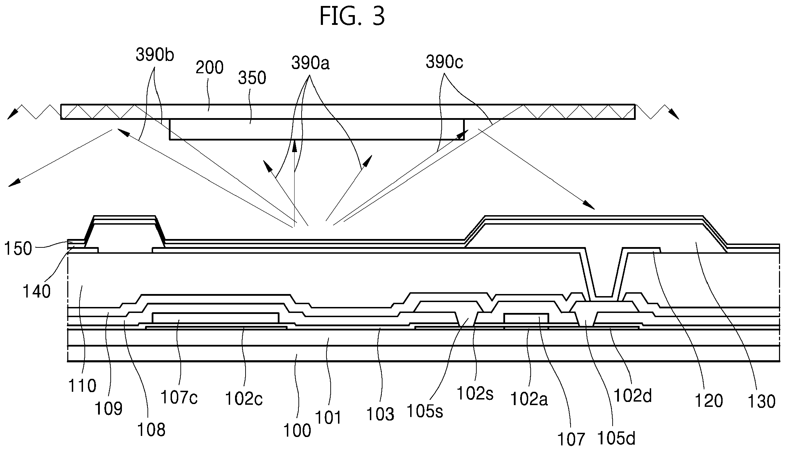

**FIG. 3** is a sectional view showing the configuration of an organic light emitting display panel with a transmission function. **FIG. 3** is also a sectional view of a pixel of the transmission display panel.

As shown in **FIG. 3****,** a color filter 350 is arranged on a second substrate 200. Due to a distance between the second substrate 200 and an organic light emitting layer 140 of a first substrate 100, some 390a of light emitted from the organic light emitting layer 140 travels upward, whereas some 390b and 390c is totally reflected toward an edge, which may result in reduction of luminance efficiency.

As described with reference to **FIGS. 2** and **3****,** the display panel with the mirror function or the transmission function has reduced luminance efficiency since some light is totally reflected toward the edge due to a top plate bonding structure. Therefore, there is a need of a structure allowing light to be output externally in a display panel with the transmission function or the mirror function.

Hereinafter, a display panel and a display device which are capable of improving luminance efficiency by using a low refractive reversed taper structure will be described. The display panel includes a first substrate having a pixel region and an emission region which are defined by a plurality of gate lines and a plurality of data lines, and a second substrate on which a partition is disposed. The partition of the second substrate in the display panel has a reversed taper structure. When implementing a mirror display device, the present invention involves a display panel in which a partition is arranged on a substrate on which a reflector is formed, or located.

A display panel and a display device include a structure in which two substrates are bonded to face with each other. A display panel may be an organic light emitting display panel or an organic light emitting display device, or a liquid crystal display panel or a liquid crystal display device. However, the present invention is not limited thereto but may be applied to different display devices and display panels with a transmission or mirror function. The common structure of the display panel of the present invention is a structure including a first substrate or lower substrate formed, or located, thereon with thin film transistors for controlling pixels and gate lines and data lines connected to the thin film transistors, and an opposing second substrate or upper substrate on which a partition is arranged. In particular, the present invention can be applied to a mirror display device or a transmission display device and can improve luminance efficiency of these display devices.

Hereinafter, a low refractive index reversed taper structure formed, or located, on the second substrate or upper substrate is referred to as a partition. The partition is disposed to correspond to an emission region or pixel region of the first substrate (lower substrate). The partition may be formed of a negative photoresist. When the negative photoresist is deposited (coated) and developed, it is possible to form a reversed taper structure and control a range of luminance viewing angle depending on an angle of taper.

Hereinafter, a second substrate constituting the display panel 11 shown in **FIG. 1** will be described. More specifically, the second substrate is bonded to a first substrate to form the display panel 11. The first substrate is formed, or located, thereon with a plurality of gate lines to which a gate signal is applied, a plurality of data lines to which a data signal is applied, a plurality of pixels defined at intersections of the data lines and the data lines, and a bank defining a pixel emission region. The second substrate has a partition formed, or located, to correspond to the bank region.

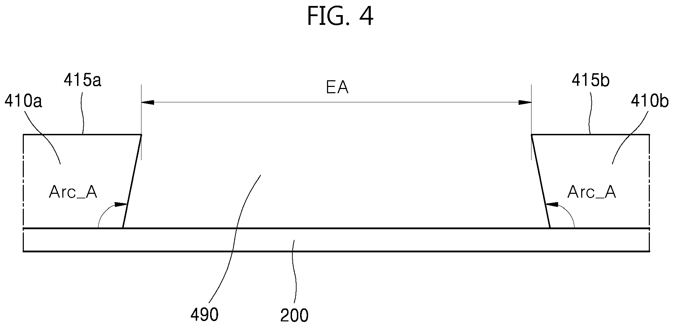

**FIG. 4** is a sectional view of a substrate on which partitions are formed, or located, according to one embodiment not forming part of the present invention. Each of partitions formed, or located, on the second substrate (i.e., an upper substrate) has a reverse taper structure. A reverse taper structure may be considered to be any structure with an associated width that increases as the distance from the second substrate is increased. For example, as shown in **FIG. 4****,** partitions 410a and 410b are formed, or located, on an upper substrate, i.e., the second substrate 200. An emitting area (EA) in which the partitions 410a and 410b are not formed, or located, corresponds to an emission area in a pixel region. The emission area may be considered to be the area from which light is emitted. The EA emits light when an organic layer emits light according to pixel control. A material of which the partitions 410a and 410b are made has a lower refractive index than a material formed, or located, in a region 490 where light is emitted and transmitted. As a result, the partitions 410a and 410b cause the light generated due to the emission of the organic layer to be travelled to the second substrate (i.e., the upper substrate 200) without being totally reflected toward an edge.

If the material formed, or located, in the region 490 where light is emitted and transmitted is an adhesive material for bonding the upper substrate and the lower substrate together, the partitions 410a and 410b can be deposited and formed by using a material having a smaller refractive index than the adhesive material. Accordingly, since the refractive index of the partitions 410a and 410b is smaller than the material over the emission area, the partitions 410a and 410b can reflect the light to be travelled toward the second substrate, which may result in improvement of luminance efficiency.

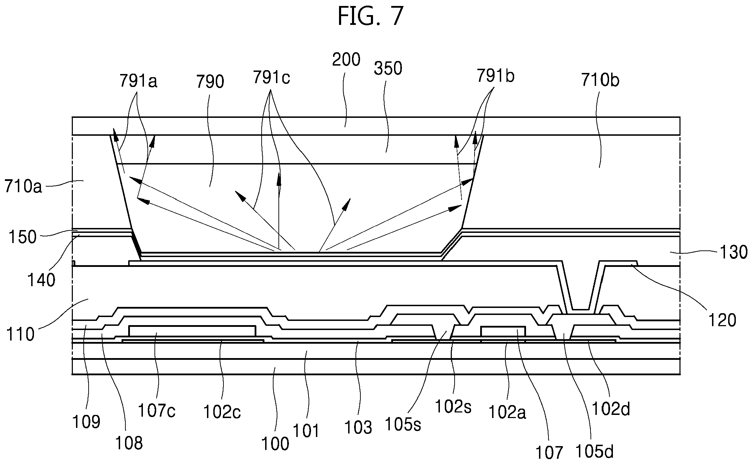

In particular, it is possible to control the luminance efficiency by selecting an adhesive material which has a larger refractive index than the partitions and bonds the first substrate and the second substrate together in the emission area. This can be verified in a process of light emission due to a refractive index difference in a propagation direction of light 791a and 791b (see **FIG. 7** which will be described later).

An angle Arc A formed between a section (substrate side section) where the partitions 410a and 410b are in contact and a side wall of the partitions 410a and 410b is equal to or greater than 90 degrees. In this case, light propagating at a low angle can also be output in front. The partitions tapered reversely with respect to the second substrate can prevent light between banks from being laterally totally reflected, which can result in increase in the output (luminance) efficiency of light emitted from the organic layer.

A section facing a bank portion of the first substrate (i.e., the lower substrate) in the partitions 410a and 410b, which will be described later, is referred to as a bank side section. In **FIG. 4****,** reference numeral 415a denotes a bank side section of the partition 410a and reference numeral 415b denotes a bank side section of the partition 410b. The bank side sections 415a and 415b may or not contact a bank of the lower substrate. In addition, an adhesive material may be coated on the bank side sections 415a and 415b so as to maintain a state of adhesion between the upper substrate and the lower substrate.

**FIG. 5** is a sectional view of a substrate on which partitions are formed, or located, according to one embodiment of the present invention, in which a lateral side of each partition has a concave polygonal surface.

As shown in **FIG. 5****,** the lateral side of each of partitions 510a and 510b formed, or located, on the second substrate 200 is not flat. Referring to the partition 510a, the partition 510a has a concave polygonal surface combining two faces 511a and 512a.

The angle Arc_B formed between the face 511a and the substrate side section of the partition is smaller than the angle Arc_C formed between the face 512a and a face parallel to the substrate side section of the partition. This can increase the light output efficiency.

Similarly, the other partition 510b has a concave polygonal surface combining two faces 511b and 512b.

After depositing a material (for example, a negative photoresist) used to form the partitions to provide the structure as shown in **FIG. 5** on the second substrate (i.e., the upper substrate 200), when the material is exposed or etched using a halftone mask, the partitions can have a two-step reversed taper structure by adjusting exposure time or exposure amount.

Although **FIG. 5** shows the section of the second substrate on which the partitions having the two-step reversed taper structure are formed, or located, the present invention is not limited thereto. For example, the partitions may have a three or more-step reverse taper structure, which falls within the scope of the invention defined in the claims.

In **FIG. 5****,** bank side sections 515a and 515b may or may not contact a bank of the lower substrate. In addition, an adhesive material may be coated on the bank side sections 515a and 515b so as to maintain a state of adhesion between the upper substrate and the lower substrate.

If a material formed, or located, in a region 590 where light is emitted and transmitted is an adhesive material for bonding the upper substrate and the lower substrate together, the partitions 510a and 510b can be deposited and formed by using a material having a smaller refractive index than the adhesive material. On the other hand, in the absence of adhesive material, it is possible to form the partitions by using a material having a lower refractive index than a material the region 590 through which light transmits.

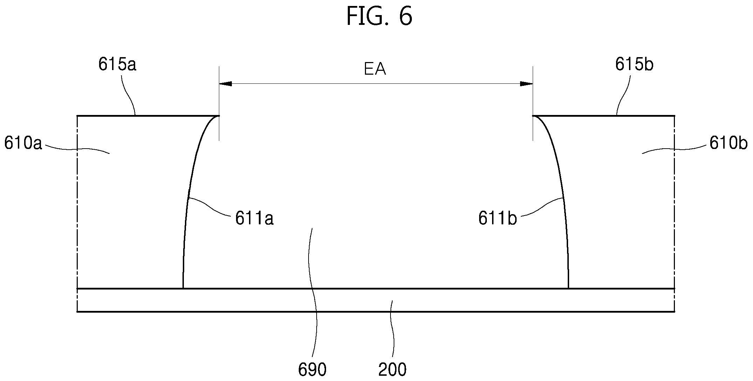

**FIG. 6** is a sectional view of a substrate on which partitions are formed, or located, according to still another embodiment not forming part of the present invention, in which a lateral side of each partition has a concave arc-shaped surface.

As shown in **FIG. 6****,** the lateral side of each of partitions 610a and 610b formed, or located, on the second substrate 200 is not flat. Referring to the partition 610a, the partition 610a has a concave arc-shaped surface 611a. Similarly, the partition 610b has a concave arc-shaped surface 611b.

After depositing a material (for example, a negative photoresist) used to form the partitions to provide the structure as shown in **FIG. 6** on the second substrate (i.e., the upper substrate 200), when the material is exposed or etched using a halftone mask, the partitions can have a concave reversed taper structure by gradually increasing exposure time or exposure amount.

In **FIG. 6****,** bank side sections 615a and 615b may or not contact a bank of the lower substrate. In addition, an adhesive material may be coated on the bank side sections 615a and 615b so as to maintain a state of adhesion between the upper substrate and the lower substrate.

If a material formed, or located, in a region 690 where light is emitted and transmitted is an adhesive material for bonding the upper substrate and the lower substrate together, the partitions 610a and 610b can be deposited and formed by using a material having a smaller refractive index than the adhesive material. On the other hand, in the absence of adhesive material, it is possible to form the partitions by using a material having a lower refractive index than a material of the region 690 through which light transmits.

As described above with reference to **FIGS. 4** to **6****,** when the partitions are formed, or located, the light emitted from the emission area can be travelled toward the upper substrate 200, which can result in improvement of the luminance efficiency. The partitions shown in **FIGS. 4** to **6** have a smaller refractive index than the material formed, or located, in the regions 490, 590 and 690 where the light is emitted and transmitted. In one embodiment, a low refractive index organic film may be used to form the partitions. In one embodiment, the organic film may have a refractive index smaller than 1.53 (i.e., n<1.53).

Although not shown, a separate reflective material may be formed, or located, on a lateral side of each of the partitions shown in **FIGS. 4** to **6****,** thereby further improving the light output efficiency. In particular, in a case of a mirror display panel, since partitions are formed, or located, on an extension surface of a mirror, it is possible to improve the output efficiency of light emitted from an organic layer without impairing visibility.

**FIG 7** is a view showing the configuration of a display panel according to one embodiment not forming part of the present invention. The first substrate 100, the thin film transistors, the data lines and the gate lines and so on, which are formed, or located, on the first substrate 100, have the same configurations as described above and, therefore, explanation of which will not repeated for the purpose of brevity.

Partitions 710a and 710b are formed, or located, in a region corresponding to the bank 130. An adhesive material such as a resin may be formed, or located, in a region 790. A refractive index of the partitions 710a and 710b may be smaller than that of the adhesive material in the region 790.

In the configuration of **FIG 7****,** some 791c of light emitted from the organic light emitting layer 140 travels toward the second substrate 200. On the other hand, some light 791a and 791b travelling toward the partitions 710a and 710b is reflected toward the second substrate 200 due to the smaller refractive index of the partitions 710a and 710b.

The display panel of **FIG. 7** becomes a transparent display panel when the data lines, the data lines, the thin film transistors, the first electrode, the second electrode and so on formed, or located, on the lower substrate are made of a transparent material. In this case, the color filter 350 can be used to decrease reflection of wirings and haze and the inversed tapered partitions 710a and 710b formed, or located, in the vicinity of the emission are can be used to increase the light output efficiency. In one embodiment, the color filter 350 is interposed between the partitions 710a and 710b in correspondence to the emission area and is set to be lower than or flush with the partitions 710a and 710b.

To summarize, in one embodiment of **FIG. 7****,** the transparent display panel includes gate lines and data lines made of a transparent conductive material and can be fabricated by selecting a material of the partitions such that the light transmittance of the partitions corresponding to the bank region is equal to or greater than the light transmittance of the first substrate. In this case, since external light can pass through the partitions, it is possible to fabricate the transparent display panel. In addition, it is possible to increase the luminance efficiency by outputting light emitted from the emission area toward the second substrate due to the refractive index of the partitions.

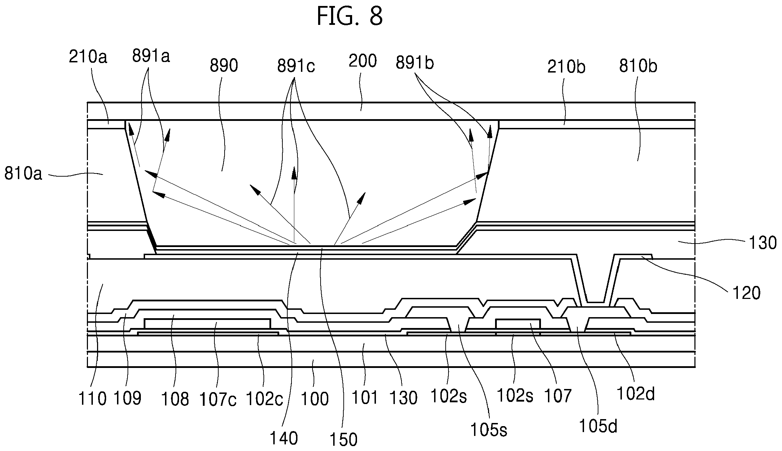

**FIG. 8** is a view showing the configuration of a mirror display panel according to another embodiment not forming part of the present invention. The first substrate 100, the thin film transistors, the data lines and the gate lines and so on, which are formed, or located, on the first substrate 100, have the same configurations as described above and, therefore, explanation of which will not repeated for the purpose of brevity.

Partitions 810a and 810b are formed, or located, in a region corresponding to the bank 130. As shown in **FIG. 8****,** the partitions 810a and 810b may be formed, or located, on mirrors 210a and 210b, respectively. An adhesive material such as a resin may be formed, or located, in a region 890. A refractive index of the partitions 810a and 810b may be smaller than that of the adhesive material in the region 890.

In the configuration of **FIG. 8****,** some 891c of light emitted from the organic light emitting layer 140 travels toward the second substrate 200. On the other hand, some light 891a and 891b travelling toward the partitions 810a and 810b is reflected toward the second substrate 200 due to the smaller refractive index of the partitions 810a and 810b.

As shown in **FIG. 8****,** in order to fabricate the mirror display panel, the reverse tapered partitions 810a and 810b can be formed in an exposure manner by patterning the mirrors 210a and 210b by sputtering, exposing and etching metal having a high reflectivity in compliance with the emission area 890, and then coating a high refractive index organic film thereon. As described above, a negative photoresist may also be used without being limited thereto.

Although not shown, a separate reflective material may be formed, or located, on a lateral side of each of the partitions 810a and 810b shown in **FIG. 8****,** thereby further improving the light output efficiency. In particular, in a case of a mirror display panel, since partitions are formed, or located, on extension surfaces of mirrors, it is possible to improve the output efficiency of light emitted from the organic layer without impairing visibility.

The partitions shown in FIGS. 7 and 8 are examples of the partitions shown in **FIG. 4****.** However, the present invention is not limited thereto. For example, the partitions having the concave polygonal surfaces or the concave arc-shaped surface shown in **FIGS. 5** and **6** may be applied to the structures shown in **FIGS. 7** and **8****.** Like **FIG. 7****,** the color filter 350 shown in **FIG. 7** may also be formed as shown in **FIG. 8****.** In this case, in one embodiment, the color filter 350 shown in **FIG. 7** is interposed between the partitions 810a and 810b in correspondence to the emission area and is lower than or flush with the partitions 810a and 810b.

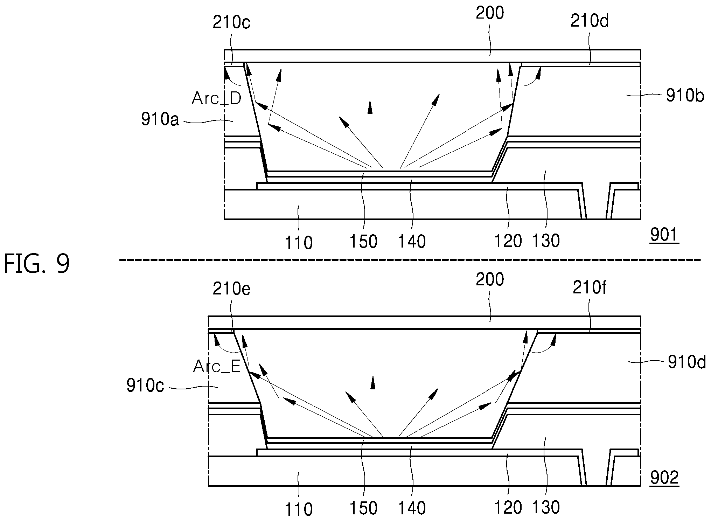

**FIG. 9** is a view showing a relationship between a reverse taper angle of partitions according to one embodiment not forming part of the present invention and a viewing angle.

As shown, a comparison can be made between a mirror display panel 901 and a mirror display panel 902 in terms of a total aperture ratio of a highly-reflective metal material constituting a mirror and a reverse taper angle of partitions.

In the mirror display panel 901, metal mirrors 210c and 210d are formed and an angle formed between partitions 910a and 910b and the second substrate 200 or the mirrors 210c and 210d is denoted by Arc_D. In the mirror display panel 902, metal mirrors 210e and 210f are formed and an angle formed between partitions 910c and 910d and the second substrate 200 or the mirrors 210e and 210f is denoted by Arc_E.

In comparison between the mirror display panels 901 and 902, the aperture ratio of the metal constituting the mirrors 210c and 210d of the mirror display panel 901 is lower than the aperture ratio of the metal constituting the mirrors 210e and 210f of the mirror display panel 902. In addition, the reverse taper angle Arc D of the mirror display panel 901 is smaller than the reverse taper angle Arc E of the mirror display panel 902. As a result, the mirror display panel 901 provides the luminance efficiency for a narrow viewing angle and the mirror display panel 902 provides the luminance efficiency for a wide viewing angle.

Therefore, depending on characteristics of a display device, the reverse taper angle of the partitions can be decreased for the narrow viewing angle. To this end, exposure time and exposure amount can be adjusted.

On the contrary, the reverse taper angle of the partitions can be decreased for the wide viewing angle. To this end, exposure time and exposure amount can be adjusted.

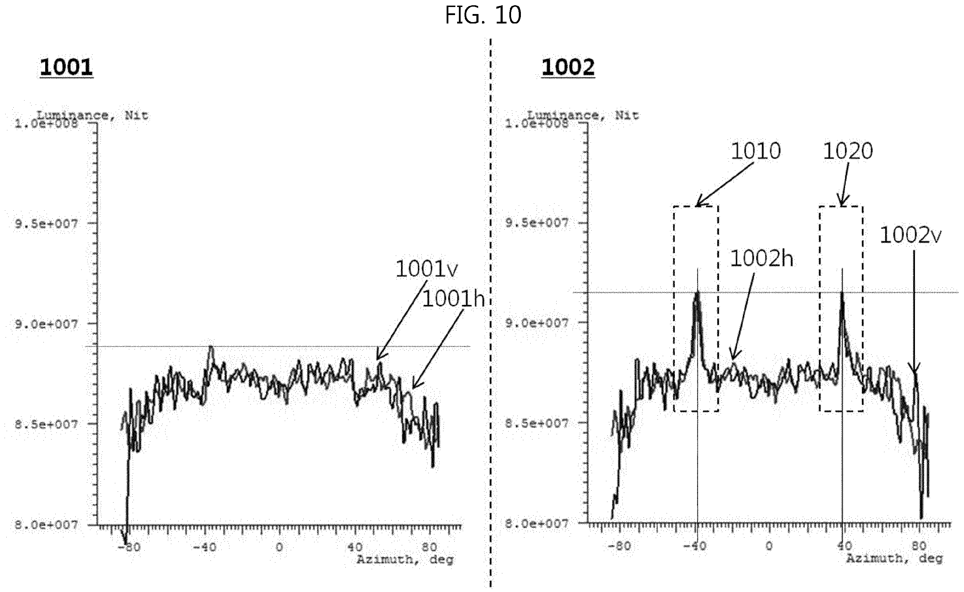

**FIG. 10** is a view showing a degree of improvement of luminance efficiency when a reverse tapered low refractive index organic film according to one embodiment not forming part of the present invention is used to form partitions. As one example, a result of simulation for a mirror display device will be described below.

A graph 1001 shows a change in vertical viewing angle 1001v and horizontal viewing angle 1001h in the display panel structure as shown in **FIG. 2****.** A graph 1002 shows a change in vertical viewing angle 1002v and horizontal viewing angle 1002h in the display panel structure as shown in **FIG. 8****.** It can be seen from the graph 1002 that luminance is increased by about 4.8% near a one side viewing angle of 40 degrees (in a range from 37 degrees to 43 degrees) (see reference numerals 1010 and 1020).

As described earlier, when different reverse taper angles are employed as shown in **FIG. 5****,** the luminance efficiency is increased, as will be described below in more detail.

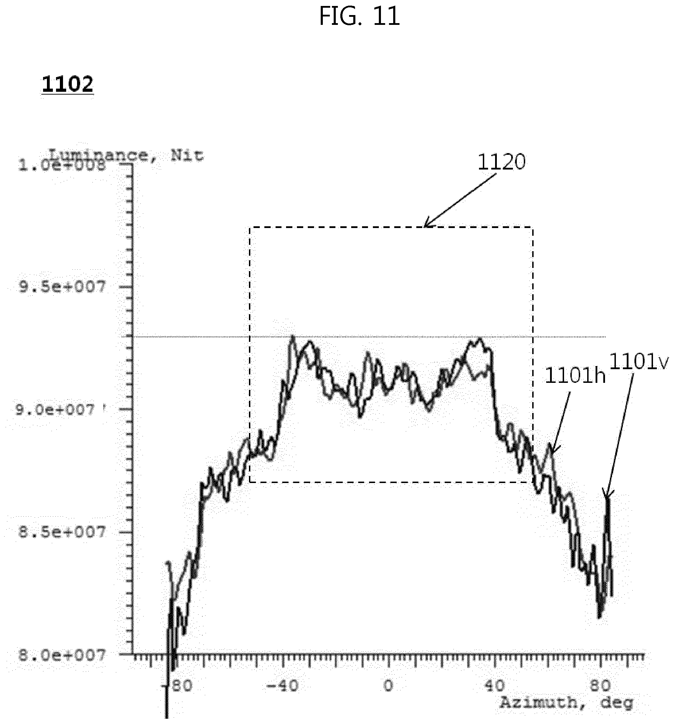

**FIG. 11** is a view showing a degree of improvement of luminance efficiency when a two-step reverse tapered low refractive index organic film according to an embodiment of the present invention is used to form partitions. As one example, a result of simulation for a mirror display device with the partitions shown in **FIG. 4** will be described below. In comparison between the graphs 1001 and 1002 of **FIG. 10****,** it can be confirmed in a graph 1102 of **FIG. 11** that the vertical viewing angle 1101v and the horizontal viewing angle 1101h are both increased (see reference numeral 1120).

As described above with reference to **FIGS. 10** and **11****,** when partitions are formed in a multi-step shape or a concave arc shape, the luminance efficiency is increased. In addition, it is possible to control a luminance viewing angle by adjusting a reverse taper angle of the partitions.

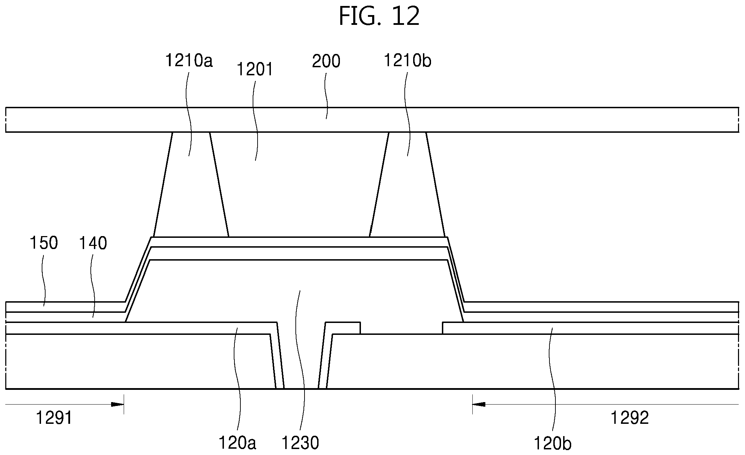

**FIG. 12** is a view showing the configuration of partitions according to another embodiment not forming part of the present invention. The partitions are formed, or located, on the second substrate corresponding to a bank region but may not be necessarily formed, or located, in the entire bank region.

As shown in **FIG. 12****,** a bank 1230 is formed, or located, between two emission areas 1291 and 1292 to define pixel regions or the emission areas 1291 and 1292. The partitions 1210a and 1210b facing the bank 1230 may be formed, or located, on the second substrate 200 in alignment with a boundary of the bank 1230. In this case, in a space 1201 between the partitions 1210a and 1210b, a separate material may not be formed, or located, or an adhesive material for bonding may be formed, or located. This can help to increase the luminance efficiency of light emitted from the emission areas and a force of adhesion of the display panel to the substrate.

A method of fabricating the display panel as described above includes a step of forming a bank defining an emission area on a first substrate, and a step of forming partitions in a region of a second substrate. This method further includes a step of forming the partitions formed on the second substrate such that the partitions have a reverse taper structure. In addition, this method further includes a step of coating and exposing a negative photoresist in order to form reverse tapered partitions on the second substrate in the display panel.

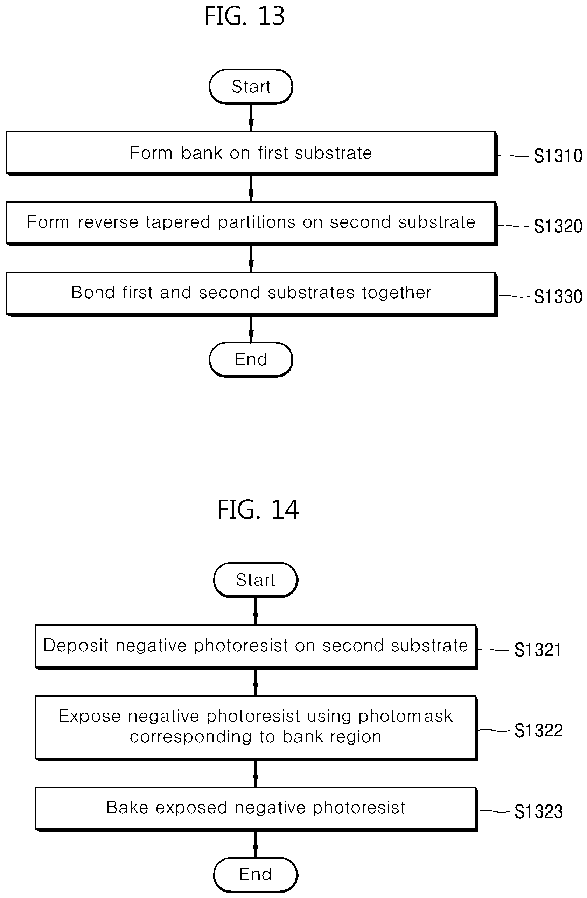

**FIG. 13** is a view showing a process of fabricating a display panel according to one embodiment. Referring to **FIG. 13****,** first, on a first substrate a plurality of gate lines are formed, or located, to which a gate signal is applied, a plurality of data lines to which a data signal is applied, a plurality of pixels defined at intersections of the gate lines and data lines, and a bank region defining an emission area (S1310). Next, reverse tapered partitions are formed, or located, on a second substrate to be bonded with the first substrate (S1320). At this time, the partitions corresponding to the bank region may be formed, or located, to correspond to the entire bank region, as described above with reference to **FIGS. 3** to **8****,** or may be formed, or located, to correspond to an edge of the bank region, as described above with reference to **FIG.12****.** Then, the two substrates (the first and second substrates) are bonded together (S1330).

In forming the partitions on the second substrate, in a case of a mirror display device, after highly-reflective metal for a mirror is formed, or located, on the second substrate, a low refractive index reverse taper structure may be formed. The low refractive index reverse taper structure is one example of the partitions.

When color filters are formed, or located, on the second substrate, a low refractive reverse taper structure can be formed after color filters corresponding to RGB and a black matrix are formed, or located. The low refractive index reverse taper structure is one example of the partitions.

In the process shown in **FIG. 13****,** the refractive index of the partitions is lower than the refractive index of a material interposed between the emission area and the second substrate. To this end, a low refractive index organic film may be used to form the partitions.

In the bonding step S1330, the two substrates can be bonded together by forming, or locating, an adhesive material in a region in the second substrate where no partition is formed, or located. In one embodiment, as shown in **FIGS. 3** to **8****,** an adhesive material may be formed, or located, in the emission area. In this case, the refractive index of the partitions is set to be lower than the refractive index of the adhesive material. For example, the refractive index of the adhesive material may be higher than the refractive material of the partitions. On the other hand, as shown in **FIG. 12****,** if the partitions are formed, or located, in an edge region of the bank and an adhesive material is formed, or located, in a vacant central portion, the refractive indexes of the partitions and the adhesive material may be independent of each other.

**FIG. 14** is a view for explaining the partition forming process according to one embodiment in more detail.

In more detail for the step S1320, a negative photoresist is deposited on the second substrate (S1321) and a photomask corresponding to the bank region of the first substrate is used to expose the negative photoresist, thereby forming the partitions (S1322). Since the negative photoresist is cured when receiving light, the partitions can have the reverse tapered lateral side shown in **FIGS. 4****,** **5** and **6****.** In addition, a baking process of curing the exposed negative photoresist may be selectively performed to maintain the shape of the reverse tapered partitions (S1323).

In particular, in the exposing process, a halftone photomask or a multi-tone photomask may be used to form the lateral side of the partitions in a concave polygonal shape or a concave arc shape. It has been illustrated in **FIG. 11** that the concave polygonal shape or the concave arc shape provides the increased luminance efficiency.

Exposure time or exposure amount may be adjusted to form the lateral side of the partitions in a concave polygonal shape or a concave arc shape. In this case, the photomask used in the bank forming process may be used as it is without a separate halftone photomask or multi-tone photo mask, which can result in reduction of costs of process and production.

To summarize the fabricating process of **FIG. 13****,** a low refractive index reverse taper structure can be formed, or located, on the second substrate (or the upper substrate) in compliance with the emission area of the first substrate (or the lower substrate). The low refractive index reverse taper structure is one example of the partitions used to increase the luminance efficiency.

When a negative photoresist organic film material is coated and developed, a reverse taper structure can be formed and a desired luminance viewing angle range can be controlled depending on a taper angle. Thus, it is possible to control a variety of viewing angles of a transmission display panel, a mirror display panel and the like, thereby improving the luminance efficiency.

At this time the organic film can have a thickness such that it is in maximum contact with the bank of the lower substrate and the bank can be formed by a material absorbing light such that light emitted from each light source is totally reflected at a low refractive index film. Of course, a space may be formed, or located, between the bank and the partitions.

Additionally, the luminance efficiency can be further improved by coating a reflective material on the lateral side of the partitions. In addition, in the second substrate, a process of forming, or locating, a color filter, which is lower than or flush with the partitions, in a region corresponding to the emission area, may be added. This can be applied to a display device including a color filter. A sequence of processes of forming partitions and color filters can be determined in various ways.

To summarize, the present invention can implement a display panel and a display device which are capable of improving the luminance efficiency of a mirror display panel or a transmission display panel.

In addition, the present invention can implement a display panel and a display device which is capable of outputting light emitted from an emission area outside the display panel without being reflected by a mirror.

In addition, in the present invention, since partitions can be formed by a photomask used to form a bank, it is possible to fabricate a display panel and a display device without employing a separate photomask. That is, since the partitions can be exposed by using the photomask used to form the bank, a need to form a separate photomask is eliminated, which can result in reduction of production costs.

In addition, in fabricating the first substrate and the second substrate, it is possible to adjust a viewing angle of a display panel by forming the first substrate in the same way and forming partitions of the second substrate in various ways. For example, assume that a display panel is classified into three types depending on a viewing angle. In fabricating display panels having a narrow viewing angle, a middle viewing angle and a wide viewing angle, a second substrate for the narrow viewing angle for fabricating the narrow viewing angle display panel, a second substrate for the middle viewing angle, and a second substrate for the wide viewing angle can be separately formed, while forming a first substrate in common. This allows a reverse taper angle of partitions to be adjusted, as shown in **FIG. 9****.** This involves embodiments of forming partitions by adjusting exposure time or exposure amount or forming partitions by using a halftone or multi-tone photomask.

While the present invention has been particularly shown and described with reference to exemplary embodiments thereof, it will be understood by those skilled in the art that various changes in form and details may be made therein without departing from the scope of the appended claims.

## Claims

1. A display panel (11) comprising:
a first substrate (100) on which a plurality of gate lines, a plurality of data lines are located, a plurality of pixels defined at intersections of the gate lines and the data lines, wherein each pixel comprises a bank defining a pixel emission region from which light is emitted; and
a second substrate (200) on which partitions (510a,510b) are located in correspondence to and facing corresponding banks (130) of the first substrate (130),
wherein the partitions and the bank define a space between the emission area and the second substrate, said space being filled with a material,
wherein the refractive index of the partitions (510a,510b) is lower than the refractive index of said material (590) which is interposed between the emission area and the second substrate (200) **characterized in that** the
lateral side of the partitions has a concave polygonal shape (511 a, 512a, 511b, 512b), wherein the concave polygonal shape of the lateral side of the partitions is formed by the side walls (511a, 512a, 511b, 512b) of at least a lower partition section (511a, 511b) provided on the second substrate (200) and an upper partition section (512a, 512b) provided on the lower partition section (511a, 511b) wherein the angle (Arc_B) formed between the side wall of the lower partition section (511a, 511b) and the second substrate (200) is equal to or greater than 90 degrees and is lower than the angle (Arc_C) formed between the side wall of the upper partition section (512a, 512b) and the second substrate (200).

2. The display panel according to claim 1, wherein said material is an adhesive material bonding the first substrate (100) and the second substrate (200) together.

3. The display panel according to any one of claims 1 to 2, wherein a mirror is located on the second substrate (200), under the partitions (510a,510b), in a region corresponding to the bank region (130) of the first substrate (100).

4. The display panel according to any one of claims 1 to 2, wherein the gate lines and data lines on the first substrate (100) are made of a transparent conductive material, and
wherein the light transmittance of the region corresponding to the bank region (130) in the second substrate (200) is equal to or higher than the light transmittance of the emission area in the first substrate (100).

5. The display panel according to any one of the preceding claims, wherein a color filter (350) lower than or flush with the partitions is provided on the second substrate interposed between the partitions.

6. A display device (100) comprising:
the display panel of any one of the preceding claims;
a first driver (12) configured to apply a data signal to the data lines;
a second driver (13) configured to apply a gate signal to the gate lines; and
a timing controller (14) configured to control the first driver (12) and the second driver (13).

7. The display device according to any one of the preceding claims, wherein both of the emission area and the bank region (130) in the first substrate (100) are transparent.

8. A method of fabricating the display panel of claim 1, the method comprising:
forming a plurality of gate lines, a plurality of data lines, a plurality of pixels and a bank (130) defining an emission area of the pixels on a first substrate (100);
forming partitions (S1320) on a second substrate (200) in a region corresponding to a region where the bank (130) is formed; and
bonding the first substrate (100) and the second substrate (200) together,
wherein the partitions and the bank define a space between the emission area and the second substrate,
wherein the refractive index of the partitions is lower than the refractive index of a material (590) interposed between the emission area and the second substrate in the space, and
wherein a lateral side of the partitions has a concave polygonal shape (511 a, 512a, 511b, 512b).

9. The method according to claim 8, wherein the act of bonding includes forming in said space and adhesive material as said material.

10. The method according to claim 8 or 9, wherein the act of forming partitions (S1320) includes:
depositing (S1321) a negative photoresist on the second substrate; and
forming the partitions by exposing (S1322) the negative photoresist using a photomask corresponding to the bank region of the first substrate.

11. The method according to claim 10, wherein the act of exposing includes: exposing the negative photoresist by using a halftone photomask or a multi-tone photomask or by adjusting exposure time or exposure amount.

12. The method according to any one of claims 8 to 11, further comprising: forming a color filter (350) lower than or flush with the partitions on the second substrate interposed between the partitions in a region corresponding to the emission area.

## Patentansprüche

1. Anzeigetafel (11), umfassend:
ein erstes Substrat (100), auf dem sich mehrere Gateleitungen, mehrere Datenleitungen befinden, mehrere Pixel an Kreuzungen der Gateleitungen und der Datenleitungen definiert sind, wobei
jedes Pixel eine Bank umfasst, die ein Pixelemissionsgebiet definiert, von dem Licht emittiert wird; und
ein zweites Substrat (200), auf dem sich Partitionen (510a, 510b) in Korrespondenz zu und gegenüber entsprechenden Bänken (130) des ersten Substrats (130) befinden,
wobei die Partitionen und die Bank einen Raum zwischen dem Emissionsbereich und dem zweiten Substrat definieren, wobei der Raum mit einem Material gefüllt ist,
wobei der Brechungsindex der Partitionen (510a, 510b) unter dem Brechungsindex des Materials (590) liegt, das zwischen dem Emissionsbereich und dem zweiten Substrat (200) angeordnet ist, **dadurch gekennzeichnet, dass** die laterale Seite der Partitionen eine konkave polygone Form (511a, 512a, 511b, 512b) aufweist, wobei die konkave polygone Form der lateralen Seite der Partitionen durch die Seitenwände (511a, 512a, 511b, 512b) von mindestens einem unteren Partitionsabschnitt (511a, 511b), der in dem zweiten Substrat (200) vorgesehen ist, und einem oberen Partitionsabschnitt (512a, 512b), der in dem unteren Partitionsabschnitt (511a, 511b) vorgesehen ist, gebildet wird, wobei der Winkel (Arc_B), der zwischen der Seitenwand des unteren Partitionsabschnitts (511a, 511b) und dem zweiten Substrat (200) ausgebildet ist, größer oder gleich 90 Grad ist und kleiner ist als der Winkel (Arc_C), der zwischen der Seitenwand des oberen Partitionsabschnitts (512a, 512b) und dem zweiten Substrat (200) ausgebildet ist.

2. Anzeigetafel nach Anspruch 1, wobei das Material ein Haftmaterial ist, das das erste Substrat (100) und das zweite Substrat (200) miteinander bondet.

3. Anzeigetafel nach einem der Ansprüche 1 bis 2, wobei sich ein Spiegel auf dem zweiten Substrat (200), unter den Partitionen (510a, 510b), in einem Gebiet entsprechend dem Bankgebiet (130) des ersten Substrats (100) befindet.

4. Anzeigetafel nach einem der Ansprüche 1 bis 2, wobei die Gateleitungen und die Datenleitungen auf dem ersten Substrat (100) aus einem transparenten leitfähigen Material bestehen, und
wobei die Lichtdurchlässigkeit des Gebiets entsprechend dem Bankgebiet (130) in dem zweiten Substrat (200) größer oder gleich der Lichtdurchlässigkeit des Emissionsbereichs in dem ersten Substrat (100) ist.

5. Anzeigetafel nach einem der vorhergehenden Ansprüche, wobei ein Farbfilter (350) unter oder bündig mit den Partitionen in dem zweiten Substrat angeordnet zwischen den Partitionen vorgesehen ist.

6. Anzeigevorrichtung (100), umfassend:
die Anzeigetafel nach einem der vorhergehenden Ansprüche;
einen ersten Treiber (12), der ausgebildet ist zum Anlegen eines Datensignals an die Datenleitungen;
einen zweiten Treiber (13), der ausgebildet ist zum Anlegen eines Gatesignals an die Gateleitungen; und
einen Zeitsteuercontroller (14), der ausgebildet ist zum Steuern des ersten Treibers (12) und des zweiten Treibers (13).

7. Anzeigevorrichtung nach einem der vorhergehenden Ansprüche, wobei sowohl der Emissionsbereich als auch das Bankgebiet (130) in dem ersten Substrat (100) transparent sind.

8. Verfahren zur Herstellung der Anzeigetafel nach Anspruch 1, wobei das Verfahren umfasst:
Ausbilden von mehreren Gateleitungen, mehreren Datenleitungen, mehreren Pixeln und einer Bank (130), die einen Emissionsbereich der Pixel auf einem ersten Substrat (100) definieren,
Ausbilden von Partitionen (S1320) auf einem zweiten Substrat (200) in einem Gebiet entsprechend einem Gebiet, wo die Bank (130) ausgebildet ist; und
Bonden des ersten Substrats (100) und des zweiten Substrats (200) miteinander,
wobei die Partitionen und die Bank einen Raum zwischen dem Emissionsbereich und dem zweiten Substrat definieren,
wobei der Brechungsindex der Partitionen unter dem Brechungsindex eines zwischen dem Emissionsbereich und dem zweiten Substrat in dem Raum angeordneten Materials (590) liegt, und
wobei eine laterale Seite der Partitionen eine konkave polygone Form (511a, 512a, 511b, 512b) aufweist.

9. Verfahren nach Anspruch 8,
wobei die Handlung des Bondens das Ausbilden in den Raum und Haftmaterial als das Material beinhaltet.

10. Verfahren nach Anspruch 8 oder 9,
wobei die Handlung des Ausbildens von Partitionen (S1320) beinhaltet:
Abscheiden (S1321) eines negativen Photoresists auf dem zweiten Substrat; und
Ausbilden der Partitionen durch Exprimieren (S1322) des negativen Photoresists unter Verwendung einer Photomaske entsprechend dem Bankgebiet des ersten Substrats.

11. Verfahren nach Anspruch 10,
wobei die Handlung des Exponierens beinhaltet:
Exponieren des negativen Photoresists unter Verwendung einer Halbtonphotomaske oder einer Multiton-Photomaske oder durch Verstellen von Belichtungszeit oder Belichtungsausmaß.

12. Verfahren nach einem der Ansprüche 8 bis 11,
weiterhin umfassend:
Ausbilden eines Farbfilters (350) unter oder bündig mit den Partitionen auf dem zweiten Substrat, angeordnet zwischen den Partitionen in einem Gebiet entsprechend dem Emissionsbereich.

## Revendications

1. Panneau d'affichage (11) comprenant :
un premier substrat (100) sur lequel sont situés une pluralité de lignes de portes, une pluralité de lignes de données, une pluralité de pixels définis aux intersections des lignes de portes et des lignes de données, dans lequel chaque pixel comprend un banc définissant une région d'émission de pixel à partir de laquelle de la lumière est émise ; et
un second substrat (200) sur lequel des cloisons (510a, 510b) sont situées en correspondance et en face des bancs correspondants (130) du premier substrat (130),
dans lequel les cloisons et le banc définissent un espace entre la zone d'émission et le second substrat, ledit espace étant rempli d'un matériau,
dans lequel l'indice de réfraction des cloisons (510a, 510b) est inférieur à l'indice de réfraction dudit matériau (590) qui est interposé entre la zone d'émission et le second substrat (200), **caractérisé en ce que**
la face latérale des cloisons présente une forme polygonale concave (511a, 512a, 511b, 512b), dans lequel la forme polygonale concave de la face latérale des cloisons est formée par les parois latérales (511a, 512a, 511b, 512b) d'au moins une section de cloison inférieure (511a, 511b) prévue sur le second substrat (200) et une section de cloison supérieure (512a, 512b) prévue sur la section de cloison inférieure (511a, 511b), dans lequel l'angle (Arc_B) formé entre la paroi latérale de la section de cloison inférieure (511a, 511b) et le second substrat (200) est égal ou supérieur à 90 degrés et est inférieur à l'angle (Arc_C) formé entre la paroi latérale de la section de cloison supérieure (512a, 512b) et le second substrat (200).

2. Panneau d'affichage selon la revendication 1, dans lequel ledit matériau est un matériau adhésif connectant entre eux le premier substrat (100) et le second substrat (200) .

3. Panneau d'affichage selon l'une quelconque des revendications 1 à 2, dans lequel un miroir est placé sur le second substrat (200), sous les cloisons (510a, 510b), dans une région correspondant à la région de banc (130) du premier substrat (100).

4. Panneau d'affichage selon l'une quelconque des revendications 1 à 2, dans lequel les lignes de portes et les lignes de données présentes sur le premier substrat (100) sont constituées d'un matériau conducteur transparent, et
dans lequel la transmittance lumineuse de la région correspondant à la région de banc (130) dans le second substrat (200) est égale ou supérieure à la transmittance lumineuse de la zone d'émission dans le premier substrat (100) .

5. Panneau d'affichage selon l'une des revendications précédentes, dans lequel il un filtre coloré (350) est prévu plus bas que les cloisons ou de niveau avec celles-ci sur le second substrat interposé entre les cloisons.

6. Dispositif d'affichage (100) comprenant :
le panneau d'affichage selon l'une quelconque des revendications précédentes ;
un premier circuit d'attaque (12) configuré pour appliquer un signal de données aux lignes de données ;
un second circuit d'attaque (13) configuré pour appliquer un signal de porte aux lignes de portes ; et
un dispositif de commande de temporisation (14) configuré pour commander le premier circuit d'attaque (12) et le second circuit d'attaque (13).

7. Dispositif d'affichage selon l'une quelconque des revendications précédentes, dans lequel la zone d'émission et la région de banc (130) présentes dans le premier substrat (100) sont toutes deux transparentes.

8. Procédé de fabrication du panneau d'affichage selon la revendication 1, le procédé comprenant :
la formation d'une pluralité de lignes de portes, d'une pluralité de lignes de données, d'une pluralité de pixels et d'un banc (130) définissant une zone d'émission des pixels se trouvant sur un premier substrat (100) ;
la formation de cloisons (S1320) sur un second substrat (200) dans une région correspondant à une région où le banc (130) est formé ; et
la connexion l'un à l'autre du premier substrat (100) et du second substrat (200),
dans lequel les cloisons et le banc définissent un espace entre la zone d'émission et le second substrat,
dans lequel l'indice de réfraction des cloisons est inférieur à l'indice de réfraction d'un matériau (590) interposé entre la zone d'émission et le second substrat dans l'espace, et
dans lequel une face latérale des cloisons présente une forme polygonale concave (511a, 512a, 511b, 512b).

9. Procédé selon la revendication 8, dans lequel l'opération de connexion comprend la formation dans ledit espace et un matériau adhésif en tant que ledit matériau.

10. Procédé selon la revendication 8 ou 9, dans lequel l'opération de formation de cloisons (S1320) comprend :
le dépôt (S1321) d'une résine photosensible négative sur le second substrat ; et
la formation des cloisons en exposant (S1322) la résine photosensible négative à l'aide d'un photomasque correspondant à la région du banc du premier substrat.

11. Procédé selon la revendication 10, dans lequel l'opération d'exposition comprend :
l'exposition de la résine photosensible négative en utilisant un photomasque en demi-teintes ou un photomasque à teintes multiples ou en ajustant le temps d'exposition ou le niveau d'exposition.

12. Procédé selon l'une quelconque des revendications 8 à 11, comprenant en outre :
la formation d'un filtre coloré (350) plus bas ou de niveau avec les cloisons sur le second substrat interposé entre les cloisons dans une région correspondant à la zone d'émission.
